# EUROPÄISCHE PATENTSCHRIFT

(11) **EP 3 501 100 B1**
(45) Veröffentlichungstag und Bekanntmachung des Hinweises auf die Patenterteilung: **22.04.2020**
(21) Anmeldenummer: 17743322.4
(22) Anmeldetag: 24.07.2017
(51) Int. Cl.: H02S 40/34, H02J 3/38, H02S 50/00, H02S 40/32, H01L 31/02, H02S 40/36

(54) **TRENNVORRICHTUNG FÜR EINEN PHOTOVOLTAISCHEN STRING**
ISOLATING APPARATUS FOR A PHOTOVOLTAIC STRING
DISPOSITIF DE SÉPARATION POUR UNE CHAÎNE PHOTOVOLTAÏQUE

(30) Priorität: 17.08.2016 DE 102016115295
(43) Veröffentlichungstag der Anmeldung: 26.06.2019
(73) Patentinhaber: SMA Solar Technology AG, 34266 Niestetal (DE)
(72) Erfinder: NESEMANN, Karl, 34260 Kaufungen (DE)
(86) Internationale Anmeldenummer: PCT/EP2017/068638
(87) Internationale Veröffentlichungsnummer: WO 2018/033345

(56) Entgegenhaltungen:
- EP-A1- 2 296 244
- JP-A- H0 870 533
- US-A1- 2012 050 924
- US-A1- 2012 163 048
- US-A1- 2013 058 140
- US-A1- 2014 253 138

## Beschreibung

Die Erfindung betrifft eine Trennvorrichtung für einen photovoltaischen String, sowie eine Energieerzeugungsanlage mit einer solchen Trennvorrichtung.

Zur kostengünstigen Gestaltung von photovoltaischen Energieerzeugungsanlagen ist es wünschenswert, die verwendeten Solarmodule zu möglichst langen Serienschaltungen, sogenannten Strings, zu verbinden, um eine möglichst hohe Stringspannung zu erreichen. Eine hohe Stringspannung birgt aber gleichzeitig die Gefahr, im Falle von Isolationsfehlern innerhalb der Energieerzeugungsanlage hohe Fehlerströme zu erzeugen, die Anlagenkomponenten beschädigen können. Weiterhin können Isolationsfehler dazu führen, dass Teile der Energieerzeugungsanlage ein Potential gegenüber Erdpotential aufweisen, das außerhalb von Sicherheitsnormen liegt. Daher ist eine Absicherung von photovoltaischen Energieerzeugungsanlagen gegen Isolationsfehler erforderlich.

Aus der Schrift US 2009 0032082 A1 ist bekannt, einen String mit einem ferngesteuerten Schalter in der Stringmitte auszustatten, der den String im Fehlerfall in zwei Teile auftrennt, Die Fernsteuerung ist im oder am Wechselrichter angeordnet und öffnet den Schalter, wenn der String keine Leistung liefert, um eine Verletzung von Maximalwerten der Spannung innerhalb des Strings gegenüber Erdpotential zu verhindern. Die Fernsteuerung des Schalters in der Stringmitte erfordert zusätzlichen Aufwand durch zusätzliche Kabelverbindungen innerhalb der Energieerzeugungsanlage.

In der Schrift EP 2 296 244 A1 ist eine Photovoltaikanlage offenbart, bei denen eine Erdung am Verbindungspunkt zwischen zwei Teilstrings zusammen gemeinsam mit der Verbindung der Teilstrings aufgetrennt wird, wenn ein nach Erde fließender Strom einen Grenzwert überschreitet. Solange der Grenzwert nicht erreicht ist, wird der String an dem Verbindungspunkt effektiv geerdet.

Die Schrift US2014/0253138 A1 beschreibt ein Verfahren zur Isolationsfehlerbestimmung, in dem ein zu prüfender String mit an beiden Enden angeordneten Schaltern zeitweise von weiteren, parallelen Strings getrennt und mit einer Messeinrichtung zur Isolationsprüfung verbunden wird.

In der Schrift US2015/0050924 A1 werden Schalter an beiden Enden eines Strings einer Mehrzahl von parallelen Strings geöffnet, wenn ein Differenzstromsensor des den Schaltern zugeordneten Strings einen Erdfehler detektiert.

In den Schriften US2013/0058140 A1 und US2012/0163048 A1 werden Teilstrings mit Hilfe von Schaltern, die über einen zentralen Controller angesteuert werden, im Erdfehler- oder sonstigen Gefahrenfall aufgetrennt und teilweise auch kurzgeschlossen.

Es ist daher Aufgabe der Erfindung, einen Schalter innerhalb eines Strings einer photovoltaischen Energieerzeugungsanlage aufzuzeigen, der den String im Fall von Isolationsfehlern automatisch in Teilstrings auftrennt, ohne dass es einer externen Ansteuerung bedarf und ohne eine niederohmige Erdung des Strings vorzugeben.

Die Aufgabe wird gelöst durch eine Energieerzeugungsanlage gemäß der unabhängigen Ansprüche 1 und 2. Bevorzugte Ausführungsformen sind in den abhängigen Ansprüchen beschrieben.

Eine erfindungsgemäße photovoltaische Energieerzeugungsanlage umfasst einen ersten und einen zweiten eingangsseitig in Reihe geschalteten Wechselrichter, wobei ein Mittelpunkt der Reihenschaltung der Wechselrichter mit einer Isolationsüberwachung verbunden ist, sowie mindestens einen mit der Reihenschaltung der Wechselrichter verbundenen photovoltaischen String mit einer Vorrichtung zur elektrischen Trennung eines ersten Teils und eines zweiten Teils eines photovoltaischen Strings, die an einem ersten Anschluss und einen zweiten Anschluss der Vorrichtung angeschlossen sind. Die Vorrichtung ist somit zwischen den beiden Teilen des Strings angeordnet und weist einen Schalter und eine dazu eingerichtete Ansteuervorrichtung auf. Die Ansteuervorrichtung ist dazu eingerichtet, den Schalter zu öffnen, wenn eine an zumindest einem der Anschlüsse anliegende Spannung relativ zu einem an einem Referenzanschluss anliegenden Potential außerhalb eines vorgegebenen Wertebereichs liegt. Bevorzugt wird der Referenzanschluss hierbei mit Erdpotential verbunden, insbesondere wird der Schalter geöffnet, wenn die an zumindest einem der Anschlüsse anliegende Spannung um einen vorgegebenen Betrag vom Erdpotential abweicht.

Alternativ zu einer Reihenschaltung von zwei Wechselrichtern kann die Energieerzeugungsanlage auch nur einen Wechselrichter mit geteiltem Eingangszwischenkreis umfassen, wobei der Mittelpunkt des Eingangszwischenkreises dann mit einer Isolationsüberwachungsschaltung verbunden ist.

Die Trennvorrichtung soll hierbei keinen oder zumindest einen möglichst geringen Einfluss auf die an den Anschlüssen anliegende Spannung haben. Um dies sicherzustellen, sollte eine Messimpedanz zwischen dem ersten beziehungsweise zweiten Anschluss und dem Referenzanschluss möglichst hoch sein, insbesondere oberhalb von 10 kOhm, bevorzugt oberhalb 100 kOhm liegen.

In einer bevorzugten Ausführungsform wird der Schalter durch eine Reihenschaltung von zwei Halbleiterschaltern gebildet. Besonders bevorzugt ist der oder sind die Schalter als normal geschlossene Schalter ausgeführt, so dass die elektrische Verbindung zwischen dem ersten und dem zweiten Anschluss bei Wegfall der aktiven Ansteuerung des Schalters durch die Ansteuervorrichtung geschlossen ist. Diese Konfiguration von Schaltern erleichtert die Betriebsaufnahme zum Beispiel bei Tagesanbruch, da der String bereits verbunden ist, wenn die Leistungsproduktion durch die Solarmodule beginnt.

Eine vorteilhafte Ausgestaltung sieht vor, dass der erste und der zweite Schalter FETs (Field Effect Transistors) sind. Besonders geeignet sind hierbei JFETs (Junction FETs), wobei insbesondere der erste Schalter ein n-Kanal JFET und der zweite Schalter ein p-Kanal JFET ist. In dieser Konfiguration können die Ansteuerspannungen für den ersten und zweiten Schalter leicht durch ein geeignet dimensioniertes Netzwerk aus passiven Bauelementen, beispielsweise einem resistiven Spannungsteiler, zwischen dem ersten Anschluss, dem zweiten Anschluss und dem Referenzanschluss als Ansteuervorrichtung erzeugt werden. Alternativ können auch andere Schalter, insbesondere andere Halbleiterschalter, verwendet und auch zwei Schalter gleichen Kanaltyps (n-Kanal oder P-Kanal Schalter) kombiniert und optional ebenfalls durch ein angepasstes Netzwerk von passiven Bauelementen angesteuert werden.

Die Vorrichtung kann dazu eingerichtet sein, ein Fehlersignal zu erzeugen, wenn der oder die Schalter geöffnet werden. Dieses Fehlersignal kann an eine übergeordnete Betriebseinheit drahtlos oder drahtgebunden übermittelt werden, die auf das Fehlersignal geeignet reagiert.

Im Gegenzug kann die Ansteuervorrichtung weiterhin zum Öffnen des oder der Schalter eingerichtet sein, wenn ein entsprechendes Signal zum Öffnen der Schalter empfangen wird. Auch der Empfang des entsprechenden Signals kann drahtlos oder drahtgebunden erfolgen.

In einer Ausführung kann die Ansteuervorrichtung weiterhin dazu eingerichtet sein, den oder die Schalter nach dem Öffnen wieder zu schließen, wenn zumindest eines der folgenden Kriterien erfüllt ist
a) Ein Betrag der Differenz zwischen Erdpotential und einem Spannungsmittelwerts an dem ersten und dem zweiten Anschluss (15, 16) liegt unterhalb eines vorgegebenen Schwellwerts. Dies ist zum Beispiel der Fall, wenn der photovoltaische String nachts nicht mehr beleuchtet wird.
b) Eine vorgegebene Zeitdauer ist seit dem Öffnen vergangen. Hierbei ist nicht ausgeschlossen, dass kurz nach dem Schließen des Schalters erneut festgestellt wird, dass die Bedingung zum Öffnen des Schalters weiterhin vorliegt, sodass der Schalter umgehend wieder geöffnet wird. Es ist denkbar, dass nur eine begrenzte Anzahl von Versuchen zum erneuten Schließen des Schalters vorgesehen ist und nach der entsprechenden Anzahl von erfolglosen Versuchen ein erneutes Schließen nur aufgrund der anderen genannten Kriterien erfolgt.
c) Ein externes Signal zum Schließen wird empfangen. Dieses Signal kann drahtlos oder drahtgebunden zum Beispiel von einer übergeordneten Betriebseinheit gesendet werden.

Durch das Vorsehen eines Kriteriums zum erneuten Schließen der Schalter wird der Zeitraum, in dem der photovoltaische String aufgrund des geöffneten Schalters keine Leistung liefert, gering gehalten, da nach Wegfall der Notwendigkeit zum Öffnen des Schalters dieser wieder umgehend geschlossen werden kann.

In einer weiteren Ausführungsform kann die Ansteuervorrichtung zur elektrischen Versorgung mit einem Energiespeicher verbunden sein, beispielsweise einer Batterie oder einem Kondensator. Hierbei kann die Ladung des Energiespeichers aus einer über den oder die Schalter abfallenden Spannung eingerichtet sein. Sofern die über den oder die Schalter abfallende Spannung im geschlossenen Zustand nicht ausreicht, um den Energiespeicher zu laden, ist es denkbar, dass kurzzeitig zumindest einer der Schalter geöffnet oder in einen teilleitenden Betrieb versetzt wird, um die über dem oder die Schalter abfallende Spannung auf einen für die Ladung ausreichenden Spannungswert zu erhöhen.

Ein weiterer Aspekt der Erfindung betrifft eine photovoltaische Energieerzeugungsanlage mit einem ersten und einem zweiten eingangsseitig, das heißt auf der Gleichstromseite, in Reihe geschalteten Wechselrichtern. Ein Mittelpunkt der Reihenschaltung der Wechselrichter ist mit einer Isolationsüberwachung und hierdurch schaltbar mit einem Bezugspotential, insbesondere Erdpotential, verbunden. Alternativ kann eine erfindungsgemäße photovoltaische Energieerzeugungsanlage auch einen einzelnen Wechselrichter mit geteiltem eingangsseitigen Zwischenkreis aufweisen, wobei ein Mittelpunkt des geteilten Zwischenkreises über die Isolationsüberwachung mit Erdpotential verbunden ist.

Auf der Gleichstromseite sind die oder ist der Wechselrichter mit mindestens einem photovoltaischen String verbunden, der eine erfindungsgemäße Vorrichtung aufweist. Weist die photovoltaische Energieerzeugungsanlage eine Mehrzahl von parallel geschalteten photovoltaischen Strings auf, wird vorteilhafterweise jeder dieser Strings jeweils mit einer erfindungsgemäßen Vorrichtung ausgestattet. Bevorzugt ist die erfindungsgemäße Vorrichtung jeweils in der Mitte des photovoltaischen Strings angeordnet, wodurch die an der Vorrichtung angeschlossenen ersten und zweiten Teile des Strings die gleiche Anzahl von Solarmodulen bzw. die gleiche nominale Stringspannung aufweisen, und über den Referenzanschluss mit Erdpotential verbunden.

Besonders bevorzugt weist der String eine maximale Leerlaufspannung von mehr als 1500V auf. Durch den Einsatz der Trennvorrichtung ist es auch bei hoher Stringspannung möglich sicherzustellen, dass auch bei Auftreten eines Erdungsfehlers, der zum Auslösen einer Isolationsüberwachung und damit von einer Auftrennung einer Erdungsverbindung des Strings bzw. der photovoltaischen Energieerzeugungsanlage führt, maximale Spannungswerte des Strings gegenüber Erdpotential weiterhin eingehalten werden. Das Auftrennen der Erdungsverbindung führt zu einem Verschieben des Potentials des Strings gegenüber Erde, so dass eine hinreichend große Verschiebung dieses Potentials zum Öffnen der erfindungsgemäßen Trennvorrichtung in dem betroffenen String führt.

Im Folgenden wird die Erfindung mithilfe von Figuren dargestellt, von denen
- Fig. 1: eine erste erfindungsgemäße Ausführung einer Trennvorrichtung,
- Fig. 2a: eine zweite erfindungsgemäße Ausführung einer Trennvorrichtung mit zwei Halbleiterschaltern,
- Fig. 2b: eine dritte erfindungsgemäße Ausführung einer Trennvorrichtung in passiver Bauweise,
- Fig. 3: ein Ablaufdiagramm eines Verfahrens gemäß der Erfindung,
- Fig. 4: eine erste Energieerzeugungsanlage mit erfindungsgemäßen Trennvorrichtungen und
- Fig. 5: eine zweite Energieerzeugungsanlage mit erfindungsgemäßen Trennvorrichtungen zeigt

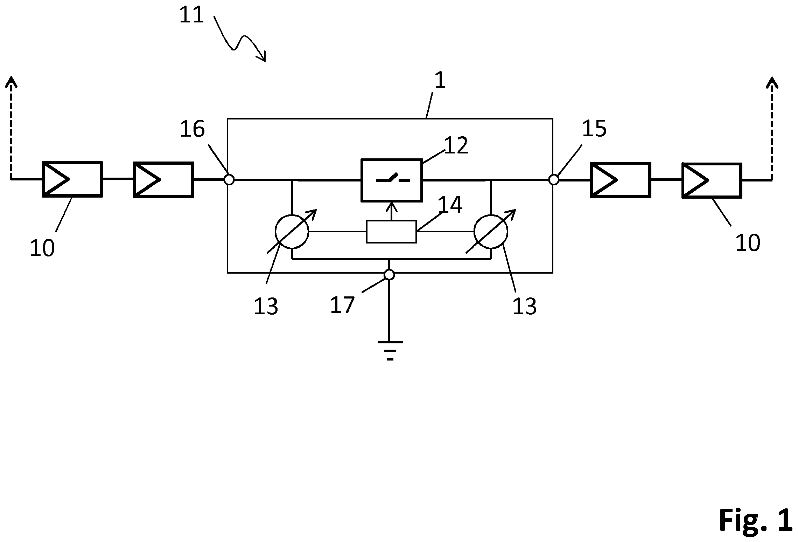

Fig. 1 zeigt einen photovoltaischen String 11 mit einer Reihenschaltung von Solarmodulen 10. Ein erster Teilstring des Strings 11 ist an einem Anschluss 15 und ein zweiter Teilstring des Strings 11 ist an einem Anschluss 16 einer Trennvorrichtung 1 angeschlossen, so dass ein Lastpfad, der die im String erzeugte Leistung führt, über die Trennvorrichtung 1 verläuft. Innerhalb der Trennvorrichtung 1 ist ein Schalter 12 zwischen den lastführenden Anschlüssen 15, 16 so angeordnet, dass er den Lastpfad gesteuert auftrennen kann. Der Schalter 12 ist hierzu mit einer Ansteuervorrichtung 14 verbunden. Die Ansteuervorrichtung 14 ist mit mindestens einem Spannungsmesser 13 verbunden, der eine Spannung zwischen einem der Anschlüsse 15, 16 und einem weiteren Anschluss 17 bestimmt, der mit Erdpotential verbunden werden kann. Bevorzugt sind zwei Spannungsmesser 13 vorgesehen und mit der Ansteuervorrichtung 14 verbunden, die jeweils mit einem der Anschlüsse 15, 16 verbunden sind.

Die Ansteuervorrichtung 14 ist derart eingerichtet, dass sie den Schalter 12 in Abhängigkeit des gemessenen Spannungswerts oder der gemessenen Spannungswerte des oder der verbundenen Spannungsmessers 13 steuert. Der Schalter 12 wird von der Ansteuervorrichtung 14 in einem geschlossenen Zustand gehalten, solange der gemessene Spannungsbetrag einen vorbestimmten ersten Grenzwert nicht übersteigt, andernfalls wird der Schalter 12 von der Ansteuervorrichtung 13 geöffnet und der Lastpfad des Strings 11 wird aufgetrennt.

Bevorzugt befindet sich die Trennvorrichtung 1 in der Mitte des Strings 11, das heißt an den beiden Anschlüssen 15, 16 sind Teilstrings gleicher Länge angeschlossen. Im Fall, dass die beiden Enden des Strings 11 eine gegenüber Erdpotential symmetrische Spannungsverteilung haben, ergibt sich an dem geschlossenen Schalter 12 ein Potential gleich oder nahe des Erdpotentials, wenn die beiden Teilstrings gleich bestrahlt sind. Bei ungleicher Bestrahlung der Teilstrings oder bei Vorliegen eines Isolationsfehlers in einem der Teilstrings ergibt sich eine Verschiebung des Schalterpotentials, die vom Spannungsmesser 13 ermittelt wird und bei ausreichender Höhe, bestimmt durch den ersten Grenzwert, zu einem Öffnen des Leistungspfades des Strings 11 führt. Hierzu ist kein externes Signal erforderlich, die Trennvorrichtung 1 überwacht den String 11 autonom.

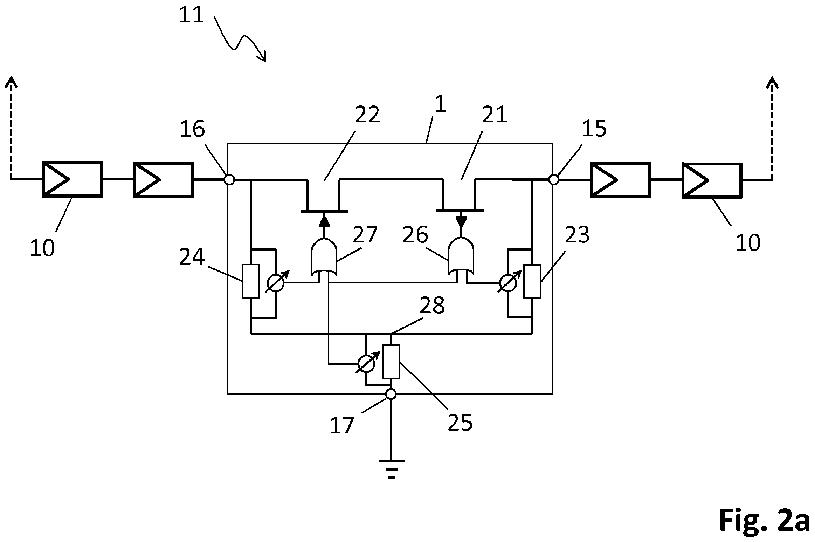

Fig. 2a zeigt eine vorteilhafte Ausführung der Erfindung, in der der Schalter der Trennvorrichtung 1 durch eine Reihenschaltung eines ersten und eines zweiten Halbleiterschalter 21, 22 gebildet ist. Bevorzugt ist der erste Halbleiterschalter 21 als p-Kanal Feldeffekttransistor (p-FET) und der zweite Halbleiterschalter 22 als n-Kanal Feldeffekttransistor (n-FET) gebildet. Besonders bevorzugt werden beide Halbleitschalter 21, 22 als normal geschlossene (normally-on) Halbleiterschalter vorgesehen.

Die beiden Teilstring-Anschlüsse 15, 16 und der weitere Anschluss 17 sind jeweils über geeignet gewählte erste, zweite und dritte Widerstände 23, 24, 25 mit einem gemeinsamen Verbindungspunkt verbunden, so dass sie einen Spannungsteiler bilden. Die an den Widerständen 23, 24, 25 abfallenden Spannungswerte werden über jeweilige Spannungsmesser 13 erfasst. Bevorzugt vergleichen die Spannungsmesser 13 die gemessenen Spannungswerte mit hinterlegten Grenzwerten und geben das Ergebnis des Vergleichs mittels eines digitalen Vergleichssignals aus. Das Vergleichssignals des Spannungsmessers 13 am ersten Widerstand 23 wird an einen ersten Gattereingang eines ersten Gatters 26, das Vergleichssignals des Spannungsmessers 13 am zweiten Widerstand 24 wird an einen ersten Gattereingang eines zweiten Gatters 27, und das Vergleichssignals des Spannungsmessers 13 am dritten Widerstand 25 wird jeweils an einen zweiten Gattereingang des ersten Gatters 26 und des zweiten Gatters 27 übermittelt. Der Gatterausgang des ersten Gatters steuert den ersten Halbleiterschalter 21 und der Gatterausgang des zweiten Gatters steuert den zweiten Halbleiterschalter 22 an.

Bevorzugt sind der erste Widerstand 23 und der zweite Widerstand 24 mit gleichem Wert gewählt, und in den ihnen zugeordneten Spannungsmessern 13 sind gleiche Grenzwerte hinterlegt. Um einen Einfluss auf die Spannung an den Anschlüssen 15, 16 möglichst gering zu halten, sind die Widerstandswerte der Widerstände 23, 24, 25 möglichst hoch zu wählen, insbesondere sollte der Gesamtwiderstand des Widerstandsnetzwerks nicht weniger als 10 kOhm betragen.

Die Versorgung der Ansteuervorrichtung 14 erfolgt vorteilhafterweise über den Spannungsabfall über den Schalter 12 beziehungsweise einen oder beide Halbleiterschalter 21, 22, so dass eine zusätzliche Stromversorgung entfällt. Da der Spannungsabfall im geschlossenen Zustand dieses oder dieser Schalter zur Versorgung regelmäßig zu gering ist, kann vorgesehen sein, dass dieser oder diese Schalter von der Ansteuervorrichtung 14 kurzzeitig geöffnet werden, um einen die Ansteuervorrichtung 14 versorgenden Energiespeicher, beispielsweise einen Kondensator, wieder aufzuladen, wenn dessen Ladezustand unter ein vorgegebenes Niveau gefallen ist. Anstelle eines vollständigen Öffnens des oder der Schalter kann auch ein kurzzeitiges Versetzen in einen teilleitenden Zustand vorgesehen sein, in dem ein für das Wiederaufladen ausreichender Spannungsabfall über den oder die Schalter erreicht wird.

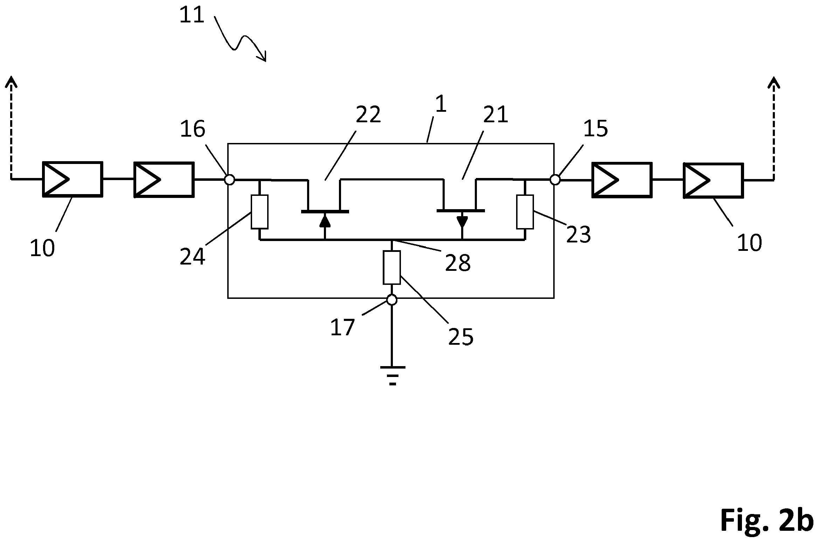

Eine beispielhafte Ausführungsform, die ohne eine solche Energieversorgung auskommt, ist in Fig. 2b gezeigt. Anstelle von Spannungsmessern 13 und Gattern 26, 27 ist hier lediglich das in Fig. 2a bereits gezeigte Widerstandsnetzwerk der ersten, zweiten und dritten Widerstände 23, 24, 25 vorhanden. Der durch diese Widerstände gebildete Spannungsteiler erzeugt direkt die zur Ansteuerung der Halbleiterschalter 21, 22 erforderlich Steuerspannungen, indem die jeweiligen Gate-Anschlüsse der Halbleiterschalter 21, 22 an den gemeinsamen Verbindungspunkt des Spannungsteilers angeschlossen sind. Hierdurch entfällt die Notwendigkeit einer Versorgung der Ansteuerschaltung, da diese nur aus passiven Bauelementen besteht. Natürlich sind weitere passive Bauelemente, zum Beispiel Kondensatoren, die parallel zu den Widerständen 23, 24, 25 angeordnet sind, denkbar. Hierdurch ist insbesondere eine zeitliche Verzögerung der Ansteuerung der Halbleiterschalter 21, 22 realisierbar, um die Trennvorrichtung 1 unempfindlich gegenüber kurzzeitigen Spannungsschwankungen zu machen. Auch andere Anordnungen von resistiven oder kapazitiven Spannungsteilern zwischen den Anschlüssen 15, 16 und 17 sind denkbar, um die jeweiligen Grenzwerte zu definieren, bei deren Erreichen die Halbleiterschalter 21, 22 geöffnet oder geschlossen werden sollen, beziehungsweise um eine gewünschte Auslösedynamik der Trennvorrichtung 1 zu erreichen.

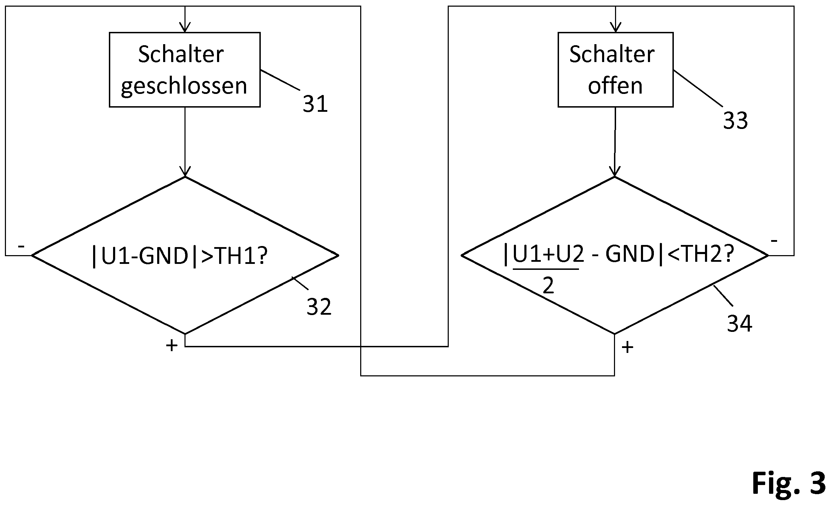

Ein beispielhaftes Verfahren zum Betrieb der Trennvorrichtung 1 ist in Fig. 3 als Ablaufdiagramm dargestellt. Ausgehend vom Schritt 31, in dem der Schalter 12 oder beide Halbleiterschalter 21, 22 geschlossen sind oder geschlossen werden, wird anschließend im Schritt 32 geprüft, ob die Spannung U1 an einem der Anschlüsse 15, 16 vom Erdpotential GND, gemessen an Anschluss 17, im Betrag mehr als ein erster Grenzwert TH1 abweicht. Ist dies nicht der Fall, wird das Verfahren zurück nach Schritt 31 verzweigt.

Übersteigt der Abweichungsbetrag den ersten Grenzwert TH1, wird zu Schritt 33 verzweigt und der Schalter 12 oder zumindest einer der Schalter 21, 22 wird geöffnet, wodurch der Lastpfad zwischen den Anschlüsse 15 und 16 aufgetrennt wird. Hierdurch wird der Stringstrom über die Trennvorrichtung 1 unterbrochen und an den angeschlossenen Solarmodulen 10 stellt sich eine Leerlaufspannung ein. Dies führt zu einer Spannungsdifferenz U1-U2 zwischen den Anschlüssen 15 und 16.

Um die Auftrennung des Lastpfades wieder rückgängig zu machen, wird anschließend im Schritt 34 geprüft, ob ein Mittelwert (U1+U2)/2 der Spannungen an den Anschlüssen 15 und 16 (ohne Einschränkung der Allgemeinheit soll im Folgenden die Spannung U1 am Anschluss 15 und die Spannung U2 am Anschluss 16 abfallen) im Betrag weniger als ein zweiter Grenzwert TH2 vom Erdpotential GND abweicht. Ist die Abweichung geringer als der zweite Grenzwert TH2, wird zum Schritt 31 verzweigt und der Schalter 12 beziehungsweise die Schalter 21 und 22 werden geschlossen, wodurch der Lastpfad zwischen den Anschlüssen 15 und 16 wiederhergestellt wird. Andernfalls kehrt das Verfahren zum Schritt 33 zurück und der Schalter 12 oder die Halbleiterschalter 21, 22 bleiben geöffnet.

In einer Abwandlung des beschriebenen Verfahrens wird anstelle des Schritts 34 nach einer vorgegebenen Zeitverzögerung der Schalter 12 oder die beiden Halbleiterschalter 21, 22 kurzzeitig geschlossen und zu Schritt 32 verzweigt, in dem dann festgestellt wird, ob der oder die Schalter geschlossen bleiben können (Verzweigung nach Schritt 31) oder wieder geöffnet werden müssen (Verzweigung nach Schritt 33). Alternativ kann das Schließen des Schalters 12 oder der beiden Halbleiterschalter 21, 22 durch den Empfang eines externen Signals bewirkt werden.

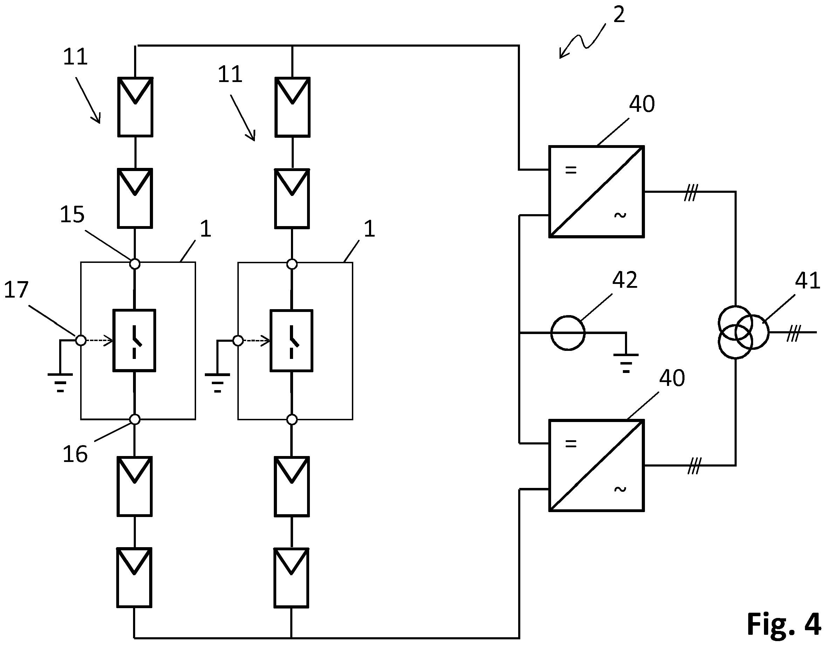

Fig. 4 zeigt eine erfindungsgemäße Energieerzeugungsanlage 2, in der die vorbeschriebene Trennvorrichtung 1 integriert ist. Eine Mehrzahl von Strings 11 mit Solarmodulen 10 ist in dieser Anlage parallel geschaltet und weisen in der Mitte der Strings 11 jeweils eine Trennvorrichtung 1 auf. Die Anschlussleitungen der Strings 11 sind jeweils mit einem von zwei gleichstromseitig in Reihe geschalteten Wechselrichtern 40 verbunden. Die Verbindungsleitung zwischen den beiden Wechselrichtern 40 ist über eine Isolationsüberwachung 42 mit Erdpotential verbunden. Wechselspannungsseitig sind die beiden Wechselrichter 40 an getrennte Primärwicklungen eines gemeinsamen Transformators 41 angeschlossen. Die Sekundärwicklung des Transformators 41 ist mit einem Energieversorgungsnetz verbunden. Bevorzugt sind die Wechselrichter dreiphasige Wechselrichter. Das Energieversorgungsnetz kann vorteilhaft ein Mittelspannungsnetz sein.

Durch die Isolationsüberwachung 42 wird im Betriebsfall sichergestellt, dass das Potential zwischen den Wechselrichtern mit Erdpotential übereinstimmt. Hierdurch ergibt sich unter der Voraussetzung einer gleichen Eingangsgleichspannung der beiden Wechselrichter 40 eine symmetrische Spannungsverteilung der Stringenden gegenüber Erdpotential, was wiederum im normalen Betriebsfall dazu führt, dass das Potential in der Stringmitte mit Erdpotential übereinstimmt. Als Folge sind die Schalter in den Trennvorrichtungen 1 und damit der Lastpfad der Strings im normalen Betriebsfall geschlossen und der Stringstrom kann ungehindert fließen.

Im Falle eines Isolationsfehlers stellt die Isolationsüberwachung 42 einen zum Erdpotential fließenden Gleichstrom fest. Übersteigt der Betrag des Gleichstroms einen vorgegebenen Maximalwert, trennt die Isolationsüberwachung in einem Beispiel eines Betriebsverfahrens die Verbindung mit dem Erdpotential auf, wodurch das Potential zwischen den Wechselrichtern nicht mehr auf Erdpotential gehalten wird. In diesem Fall bestimmt der Isolationsfehler, insbesondere der Ort des Isolationsfehlers, das sich in der Stringmitte bildende Potential. In der Regel wird es derart vom Erdpotential abweichen, dass der erste Grenzwert TH1 überschritten wird und die Trennvorrichtung 1 sich öffnet. Dies wird bei allen Trennvorrichtungen der Energieerzeugungsanlage 2 unabhängig voneinander und in analoger Weise passieren. Auch wenn der Isolationsfehler in einem der Strings 11 mit Trennvorrichtung 1 lokalisiert ist, wird der Isolationsfehler durch das Öffnen dieser Trennvorrichtung nicht behoben. Es ist an dieser Stelle hervorzuheben, dass im Fall eines Isolationsfehlers die Spannungen U1, U2 an den Anschlüssen 15 und 16 einer geöffneten Trennvorrichtung 1 nicht symmetrisch zum Erdpotential verteilt sind, also der Mittelwert der Spannungen U1 und U2 vom Erdpotential um mehr al dem zweiten Grenzwert TH2 abweicht. Daher verhindert das Ergebnis des Schritts 34 des vorstehend beschriebenen Betriebsverfahrens das erneute Schließen des Schalters 12 oder der Halbleiterschalter 21, 22, solange der Isolationsfehler wirksam ist.

Vergleichbar verhält es sich, wenn die beiden Teilstrings eines Strings 11 mit unterschiedlicher Lichtintensität bestrahlt werden, insbesondere wenn ein Teilstring gegenüber dem anderen Teilstring verschattet ist. In diesem Fall ergibt sich ebenfalls am Anschluss 15 der Trennvorrichtung 1 dieses Strings 11 eine vom Erdpotential abweichende Spannung U1, und die Trennvorrichtung trennt den Lastpfad auf. Hierdurch gehen beide Teilstrings in den Leerlaufzustand, wodurch an ihnen unterschiedliche Leerlaufspannungen abfallen, solange der Zustand unterschiedlicher Bestrahlung der Teilstrings vorhält. Da die Stringenden weiterhin eine symmetrische Spannungsverteilung gegenüber Erdpotential aufweisen, weicht auch hier der Mittelwert der Spannungen U1 und U2 an den Anschlüssen 15 und 16 der geöffneten Trennvorrichtung 1 von Erdpotential ab. Wenn beide Teilstrings aber zu einem späteren Zeitpunkt wieder gleichmäßig bestrahlt werden und ihre Leerlaufspannungen soweit übereinstimmen, dass die Bedingung des Schritts 34 erfüllt ist, wird die Bedingung des Schritts 34 des vorstehend beschriebenen Betriebsverfahrens erfüllt, und die Trennvorrichtung 1 schließt den Lastpfad eigenständig, so dass der String 11 wieder Leistung produziert.

Die Wahrscheinlichkeit einer ungleichen Bestrahlung von Teilstrings eines Strings 11, die zu einer Auftrennung des Lastpfades führt, kann durch eine Anordnung der Solarmodule 10 der Teilstrings minimiert werden, in der die Solarmodule 10 des einen Teilstrings möglichst nahe an den Solarmodulen 10 des anderen Teilstrings platziert werden. Beispielsweise können beide Teilstrings parallel direkt nebeneinander verlaufen und hierbei möglicherweise mehrfach die Seite zueinander wechseln, so dass ein miteinander verwobener Verlauf entsteht. Hierdurch betrifft ein verschattendes Objekt oder ein verschattendes Ereignis die Solarmodule 10 beider Teilstrings in ähnlicher Weise.

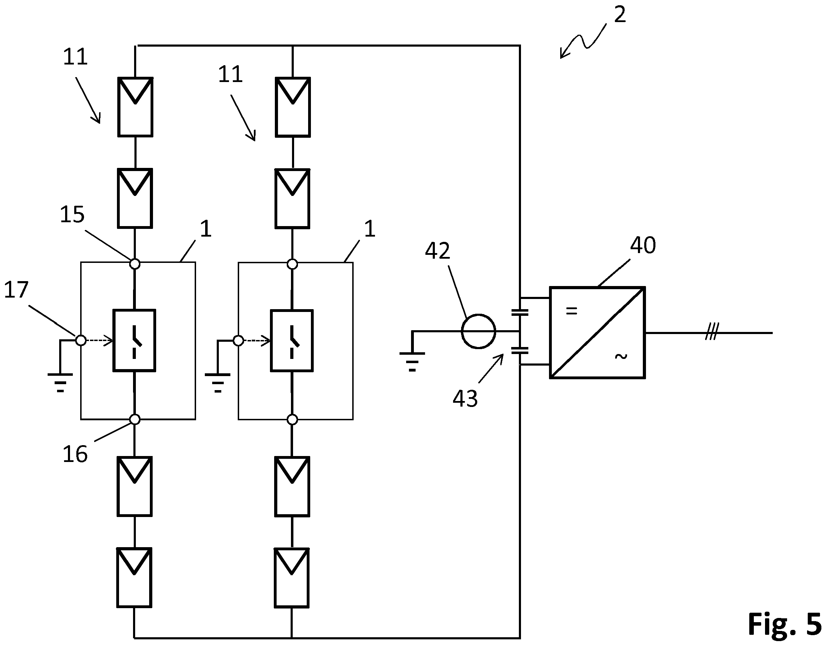

In der Ausführung einer photovoltaischen Energieerzeugungsanlage 2 nach Fig. 5 kommt nur ein einzelner Wechselrichter 40 zum Einsatz. Hier ist die Isolationsüberwachung 42 mit einem Mittelpunkt eines eingangsseitigen Zwischenkreises 43 verbunden. In dieser Anordnung muss der Wechselrichter 40 auf die gesamte Stringspannung als zulässige Eingangsspannung ausgelegt sein. Ansonsten entspricht der Betrieb diese Anlage dem in Verbindung mit der Energieerzeugungsanlage 2 der Fig. 4 Gesagten.

### Bezugszeichenliste

- 1: Trennvorrichtung
- 2: Energieerzeugungsanlage
- 10: Solarmodul
- 11: String
- 12: Trennschalter
- 13: Spannungsmesser
- 14: Ansteuervorrichtung
- 15, 16: Anschluss
- 17: Referenzanschluss
- 21, 22: Halbleiterschalter
- 23, 24, 25: Widerstand
- 26, 27: Gatter
- 28: Verbindungspunkt
- 31-34: Schritt
- 40: Wechselrichter
- 41: Transformator
- 42: Isolationsüberwachung
- 43: Zwischenkreis

## Patentansprüche

1. Photovoltaische Energieerzeugungsanlage (2), umfassend einen ersten und einen zweiten eingangsseitig in Reihe geschalteten Wechselrichter (40), wobei ein Mittelpunkt der Reihenschaltung der Wechselrichter (40) mit einer Isolationsüberwachung (42) verbunden ist, und mindestens einen mit der Reihenschaltung der Wechselrichter (40) verbundenen photovoltaischen String (11) mit einer Vorrichtung (1) zur elektrischen Trennung eines ersten Teils und eines zweiten Teils des photovoltaischen Strings (11), die an einem ersten Anschluss (15) und einen zweiten Anschluss (16) der Vorrichtung (1) angeschlossen sind,
**dadurch gekennzeichnet, dass** sich die Vorrichtung zwischen den beiden Teilen des Strings befindet, und
dass die Vorrichtung (1) einen Schalter (12, 21, 22) und eine dazu eingerichtete Ansteuervorrichtung (14) aufweist, den Schalter (12, 21,22) zu öffnen, wenn eine an zumindest einem der Anschlüsse (15, 16) anliegende Spannung relativ zu einem an einem Referenzanschluss (17) anliegenden Potential außerhalb eines vorgegebenen Wertebereich liegt.

2. Photovoltaische Energieerzeugungsanlage (2), umfassend einen Wechselrichter (40), wobei ein Mittelpunkt eines geteilten Eingangszwischenkreises des Wechselrichters (40) mit einer Isolationsüberwachung (42) verbunden ist, und mindestens einen mit dem Wechselrichter (40) verbundenen photovoltaischen String (11) mit einer Vorrichtung (1) zur elektrischen Trennung eines ersten Teils und eines zweiten Teils des photovoltaischen Strings (11), die an einem ersten Anschluss (15) und einen zweiten Anschluss (16) der Vorrichtung (1) angeschlossen sind,
**dadurch gekennzeichnet,**
**dass** sich die Vorrichtung zwischen den beiden Teilen des Strings befindet, und dass die Vorrichtung (1) einen Schalter (12, 21, 22) und eine dazu eingerichtete Ansteuervorrichtung (14) aufweist, den Schalter (12, 21,22) zu öffnen, wenn eine an zumindest einem der Anschlüsse (15, 16) anliegende Spannung relativ zu einem an einem Referenzanschluss (17) anliegenden Potential außerhalb eines vorgegebenen Wertebereich liegt.

3. Photovoltaische Energieerzeugungsanlage (2)nach Anspruch 1 oder 2, wobei der Schalter eine Reihenschaltung von zwei Halbleiterschaltern (21, 22) ist.

4. Photovoltaische Energieerzeugungsanlage (2)nach Anspruch 3, wobei der erste und der zweite Schalter (21, 22) normal geschlossene Schalter sind.

5. Photovoltaische Energieerzeugungsanlage (2) nach Anspruch 3 oder 4, wobei der erste und der zweite Schalter (21, 22) FETs, insbesondere JFETs sind.

6. Photovoltaische Energieerzeugungsanlage (2)nach Anspruch 5, wobei der erste Schalter (21) ein p-JFET und der zweite Schalter (22) ein n-JFET ist.

7. Photovoltaische Energieerzeugungsanlage (2)nach einem der vorangehenden Ansprüche, wobei eine Messimpedanz zwischen einem der Anschlüsse (15, 16) und dem Referenzanschluss (17) mindestens 10 kOhm, bevorzugt mindestens 100 kOhm beträgt.

8. Photovoltaische Energieerzeugungsanlage (2)nach einem der vorangehenden Ansprüche, wobei die Ansteuervorrichtung (14) zur Erzeugung eines Fehler-Signals eingerichtet ist, wenn der oder die Schalter (12, 21, 22) geöffnet werden.

9. Photovoltaische Energieerzeugungsanlage (2)nach einem der vorangehenden Ansprüche, wobei die Ansteuervorrichtung (14) weiterhin zum Öffnen des oder der Schalter (12, 21, 22) bei Empfang eines externen Signals eingerichtet ist.

10. Photovoltaische Energieerzeugungsanlage (2)nach einem der vorangehenden Ansprüche, wobei die Ansteuervorrichtung (14) weiterhin dazu eingerichtet ist, den oder die Schalter (12, 21, 22) nach dem Öffnen wieder zu schließen, wenn zumindest eines der folgenden Kriterien erfüllt ist:
- ein Betrag der Differenz zwischen Erdpotential und einem Spannungsmittelwert an dem ersten und dem zweiten Anschluss (15, 16) liegt unterhalb eines vorgegebenen Schwellwerts,
- eine vorgegebene Zeitdauer ist seit dem Öffnen vergangen und
- ein externes Signal zum Schließen wird empfangen.

11. Photovoltaische Energieerzeugungsanlage (2)nach einem der vorangehenden Ansprüche, wobei die Ansteuervorrichtung (14) zur elektrischen Versorgung mit einem Energiespeicher verbunden ist, der zur Ladung aus einer über den oder die Schalter (12, 21, 22) abfallenden Spannung eingerichtet ist.

12. Photovoltaische Energieerzeugungsanlage nach einem der vorangehenden Ansprüche, wobei der String eine maximale Leerlaufspannung von mehr als 1500 Volt aufweist.

13. Photovoltaische Energieerzeugungsanlage nach einem der vorangehenden Ansprüche, die eine Mehrzahl parallel geschalteter Strings mit einer Vorrichtung (1) zur elektrischen Trennung eines ersten Teils und eines zweiten Teils der photovoltaischen Strings (11) aufweist.

14. Photovoltaische Energieerzeugungsanlage nach einem der vorangehenden Ansprüche, wobei der Referenzanschluss (17) mit Erdpotential verbunden ist.

15. Photovoltaische Energieerzeugungsanlage nach einem der vorangehenden Ansprüche, wobei die Vorrichtung (1) im String (11) derart angeordnet ist, dass der String (11) beim Öffnen des oder der Schalter (12, 21, 22) in zwei Teile mit gleicher Länge aufgetrennt wird.

## Claims

1. A photovoltaic power generation system (2) comprising a first and a second inverter (40) connected in series on the input side, wherein a center point of the series connection of the inverters (40) is connected to an insulation monitoring device (42), and at least one photovoltaic string (11) connected to the series connection of the inverters (40) with a device (1) for electrically separating a first part and a second part of the photovoltaic string (11), which are connected to a first terminal (15) and a second terminal (16) of the device (1), **characterised in that** the device is located between the two parts of the string, and
**in that** the device (1) comprises a switch (12, 21, 22) and a control device (14) adapted to open the switch (12, 21, 22) when a voltage applied to at least one of the terminals (15, 16) is outside a predetermined value range relative to a potential applied to a reference terminal (17).

2. A photovoltaic power generation system (2) comprising an inverter (40), wherein a center of a divided input DC bus of the inverter (40) is connected to an insulation monitoring device (42), and at least one photovoltaic string (11) connected to the inverter (40), comprising a device (1) for electrically separating a first part and a second part of the photovoltaic string (11) connected to a first terminal (15) and a second terminal (16) of the device (1), **characterised in that** the device is located between the two parts of the string, and
**in that** the device (1) comprises a switch (12, 21, 22) and a control device (14) adapted to open the switch (12, 21, 22) when a voltage applied to at least one of the terminals (15, 16) is outside a predetermined value range relative to a potential applied to a reference terminal (17).

3. The photovoltaic power generation system (2) according to claim 1 or 2, wherein the switch is a series connection of two semiconductor switches (21, 22).

4. The photovoltaic power generation system (2) according to claim 3, wherein the first and second switches (21, 22) are normally closed switches.

5. The photovoltaic power generation system (2) according to claim 3 or 4, wherein the first and second switches (21, 22) are FETs, in particular JFETs.

6. The photovoltaic power generation system (2) according to claim 5, wherein the first switch (21) is a p-JFET and the second switch (22) is an n-JFET.

7. The photovoltaic power generation system (2) according to one of the preceding claims, wherein a measuring impedance between one of the terminals (15, 16) and the reference terminal (17) is at least 10 kOhm, preferably at least 100 kOhm.

8. The photovoltaic power generation system (2) according to one of the preceding claims, wherein the control device (14) is arranged to generate an error signal when the switch or switches (12, 21, 22) are opened.

9. The photovoltaic power generation system (2) according to one of the preceding claims, wherein the control device (14) is further adapted to open the switch or switches (12, 21, 22) when an external signal is received.

10. The photovoltaic power generation system (2) according to one of the preceding claims, wherein the control device (14) is further adapted to close the switch or switches (12, 21, 22) again after opening if at least one of the following criteria is fulfilled:
- an amount of the difference between ground potential and a voltage average value at the first and second terminals (15, 16) is below a predetermined threshold value,
- a specified period of time has elapsed since opening and
- an external signal for closing is received.

11. The photovoltaic power generation system (2) according to one of the preceding claims, wherein the control device (14) is, for electrical supply thereof, connected to an energy storage device adapted to charge from a voltage dropped across the switch or switches (12, 21, 22).

12. The photovoltaic power generation system (2) according to one of the preceding claims, wherein the string has a maximum open-circuit voltage of more than 1500 volts.

13. The photovoltaic power generation system (2) according to one of the preceding claims, comprising a plurality of strings connected in parallel, with a device (1) for electrically separating a first part and a second part of the photovoltaic strings (11).

14. The photovoltaic power generation system (2) according to any of the preceding claims, wherein the reference terminal (17) is connected to ground potential.

15. The photovoltaic power generation system (2) according to one of the preceding claims, wherein the device (1) is arranged in the string (11) in such a way that the string (11) is separated into two parts of equal length when the switch or switches (12, 21, 22) are opened.

## Revendications

1. Installation de génération d'énergie photovoltaïque (2), comprenant un premier et un deuxième onduleur (40) branchés en série du côté de l'entrée, un point central du circuit série des onduleurs (40) étant relié à une surveillance d'isolation (42), et au moins une chaîne photovoltaïque (11) reliée au circuit série des onduleurs (40) et comprenant un dispositif (1) de séparation électrique d'une première partie et d'une deuxième partie de la chaîne photovoltaïque (11), lesquelles sont raccordées à une première borne (15) et à une deuxième borne (16) du dispositif (1),
**caractérisée en ce que** le dispositif se trouve entre les deux parties de la chaîne, et
**en ce que** le dispositif (1) possède un commutateur (12, 21, 22) et un dispositif de commande (14) conçu pour ouvrir le commutateur (12, 21, 22) lorsqu'une tension appliquée à au moins l'une des bornes (15, 16) se trouve en-dehors d'une plage de valeurs prédéfinie par rapport à un potentiel appliqué à une borne de référence (17).

2. Installation de génération d'énergie photovoltaïque (2), comprenant un onduleur (40), un point central d'un circuit intermédiaire d'entrée divisé de l'onduleur (40) étant relié à une surveillance d'isolation (42), et au moins une chaîne photovoltaïque (11) reliée à l'onduleur (40) et comprenant un dispositif (1) de séparation électrique d'une première partie et d'une deuxième partie de la chaîne photovoltaïque (11), lesquelles sont raccordées à une première borne (15) et à une deuxième borne (16) du dispositif (1),
**caractérisée en ce que** le dispositif se trouve entre les deux parties de la chaîne, et **en ce que** le dispositif (1) possède un commutateur (12, 21, 22) et un dispositif de commande (14) conçu pour ouvrir le commutateur (12, 21, 22) lorsqu'une tension appliquée à au moins l'une des bornes (15, 16) se trouve en-dehors d'une plage de valeurs prédéfinie par rapport à un potentiel appliqué à une borne de référence (17).

3. Installation de génération d'énergie photovoltaïque (2) selon la revendication 1 ou 2, le commutateur étant un circuit série de deux commutateurs à semiconducteur (21, 22).

4. Installation de génération d'énergie photovoltaïque (2) selon la revendication 3, le premier et le deuxième commutateur (21, 22) étant des commutateurs fermés au repos.

5. Installation de génération d'énergie photovoltaïque (2) selon la revendication 3 ou 4, le premier et le deuxième commutateur (21, 22) étant des FET, notamment des JFET.

6. Installation de génération d'énergie photovoltaïque (2) selon la revendication 5, le premier commutateur (21) étant un p-JFET et le deuxième commutateur (22) un n-JFET.

7. Installation de génération d'énergie photovoltaïque (2) selon l'une des revendications précédentes, une impédance de mesure entre l'une des bornes (15, 16) et la borne de référence (17) étant d'au moins 10 kohms, de préférence d'au moins 100 kohms.

8. Installation de génération d'énergie photovoltaïque (2) selon l'une des revendications précédentes, le dispositif de commande (14) étant destiné à générer un signal de défaut lorsque le ou les commutateurs (12, 21, 22) sont ouverts.

9. Installation de génération d'énergie photovoltaïque (2) selon l'une des revendications précédentes, le dispositif de commande (14) étant en outre conçu pour ouvrir le ou les commutateurs (12, 21, 22) lors de la réception d'un signal externe.

10. Installation de génération d'énergie photovoltaïque (2) selon l'une des revendications précédentes, le dispositif de commande (14) étant en outre conçu pour refermer le ou les commutateurs (12, 21, 22) après l'ouverture lorsqu'au moins l'un des critères suivants est satisfait
- une valeur absolue de la différence entre le potentiel de terre et une valeur moyenne de la tension au niveau de la première et de la deuxième borne (15, 16) est inférieure à une valeur de seuil prédéfinie,
- une durée prédéfinie s'est écoulée depuis l'ouverture et
- un signal externe de fermeture est reçu.

11. Installation de génération d'énergie photovoltaïque (2) selon l'une des revendications précédentes, le dispositif de commande (14), pour l'alimentation électrique, étant relié à un accumulateur d'énergie qui est conçu pour être chargé à partir d'une tension de chute aux bornes du ou des commutateurs (12, 21, 22).

12. Installation de génération d'énergie photovoltaïque selon l'une des revendications précédentes, la chaîne possédant une tension à vide maximale supérieure à 1500 volts.

13. Installation de génération d'énergie photovoltaïque selon l'une des revendications précédentes, laquelle possède une pluralité de chaînes branchées en parallèle et comprenant un dispositif (1) de séparation électrique d'une première partie et d'une deuxième partie des chaînes photovoltaïques (11).

14. Installation de génération d'énergie photovoltaïque selon l'une des revendications précédentes, la borne de référence (17) étant reliée au potentiel de terre.

15. Installation de génération d'énergie photovoltaïque selon l'une des revendications précédentes, le dispositif (1) étant disposé dans la chaîne (11) de telle sorte que lors de l'ouverture du ou des commutateurs (12, 21, 22), la chaîne (11) est séparée en deux parties de même longueur.
